(19) Europäisches Patentamt
European Patent Office
Office européen des brevets

(11) EP 2 817 150 B1

(12) **EUROPÄISCHE PATENTSCHRIFT**

(45) Veröffentlichungstag und Bekanntmachung des Hinweises auf die Patenterteilung:
**02.11.2016 Patentblatt 2016/44**

(21) Anmeldenummer: **13707127.0**

(22) Anmeldetag: **18.02.2013**

(51) Int Cl.:
***B32B 17/10*** $^{(2006.01)}$ ***C03C 17/36*** $^{(2006.01)}$

(86) Internationale Anmeldenummer:
**PCT/EP2013/053155**

(87) Internationale Veröffentlichungsnummer:
**WO 2013/124232 (29.08.2013 Gazette 2013/35)**

(54) **MEHRSCHICHTAUFBAU ALS REFLEKTOR**

MULTI-LAYERED STRUCTURE AS A REFLECTOR

STRUCTURE MULTICOUCHE SERVANT DE RÉFLECTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.02.2012 US 201213400159**

(43) Veröffentlichungstag der Anmeldung:
**31.12.2014 Patentblatt 2015/01**

(73) Patentinhaber: **Covestro Deutschland AG**
**51373 Leverkusen (DE)**

(72) Erfinder:
- **KUHLMANN, Timo**
**42799 Leichlingen (DE)**
- **WAGNER, Michael**
**47443 Moers (DE)**
- **OSER, Rafael**
**47800 Krefeld (DE)**
- **DAVIS, Terry G.**
**Kimball, Michigan 48074 4523 (US)**
- **OSIO, Ignacio**
**Gibsonia, Pennsylvania 15044 (US)**

(74) Vertreter: **Levpat**
**c/o Covestro AG**
**Alfred-Nobel-Straße 10**
**40789 Monheim am Rhein (DE)**

(56) Entgegenhaltungen:
- **DAR-YUAN SONG ET AL: "Progress in the development of a durable silver-based high-reflectance coating for astronomical telescopes", APPLIED OPTICS, Bd. 24, Nr. 8, 15. April 1985 (1985-04-15) , Seite 1164, XP55057239, ISSN: 0003-6935, DOI: 10.1364/AO.24.001164**
- **"Society of Vacuum Coaters, 52nd,", 2009, XP002694122, Seiten 473-477, in der Anmeldung erwähnt das ganze Dokument**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die vorliegende Erfindung betrifft einen Mehrschichtaufbau zur Anwendung als Spiegel/Reflektor, im Bereich der CPV (concentrating photovoltaics) und CSP (concentrating solar power). Der Mehrschichaufbau enthält eine Substratschicht, eine Barriereschicht, eine metallische Reflektorschicht, eine oxidische Schicht und eine weitere Schicht, die eine Plasmapolymerschicht oder eine hochbrechende Metalloxidschicht sein kann.

Silberspiegel für Anwendungen im CPV- und CSP-Bereich sind bereits bekannt.

WO 2000007818 beschreibt Silberspiegel basierend auf einem polymeren Substrat mit einer hierauf unmittelbar aufgebrachten Silberschicht, welche wiederum durch eine unmittelbar auf diese aufgebrachte und fest mit dieser verbundenen polymeren Schutzschicht überlagert ist. Auf diese Polymerschicht ist ein UV absorbierender polymerer Film aufgetragen.

US 6078425 beschreibt Mehrschichtspiegel enthaltend reflektive Schichten aus Aluminium und Silber, wobei eine Haftungsschicht aus Nickel und/oder Chromlegierungen oder Nitriden auf die Aluminiumoberfläche abgeschieden wird. Die Silberschicht wird durch eine Schicht aus Nickel und/oder Chromlegierungen oder Nitriden und einer oder mehreren Schichten aus Metalloxiden geschützt.

Ausgehend von den bekannten Systemen, die aufgebaut sind aus einer Metallschicht (A1, oder Cu), einer Silberreflexionsschicht, entweder einer transparente Schutzschicht aus Aluminiumoxid oder einer Siliziumnitridschicht mit darauf aufgebrachten $SiO_2$ und Tantaloxidschichten soll in Society of Vacuum Coaters (2009), 52nd, 473-477 das komplexe Schutzschichtsystem ersetzt werden, um eine Massenproduktion mittels Kurztaktmetallisierungsanlagen zu realisieren. Hierbei sollen die hergestellten Schichtaufbauten nach wie vor über eine ausreichende Reflektivität und Witterungseigenschaften verfügen.

Society of Vacuum Coaters (2009), 52nd, 473-477 offenbart daher spezielle Mehrschichtaufbauten mit erhöhter Reflektivität und Witterungsstabilität. Es werden hierbei Schichtaufbauten beschrieben, die ein Kunststoffsubstrat, eine Metallschicht, einen darauf aufgebrachten Silberreflektor und einen Plasmasiloxan Topcoat aufweist. Hierbei erreicht der beschriebene Aufbau jedoch nicht die geforderten Anforderungen.

Aus Concentrating Photovoltaic Conference 7 (CPV 7), Las Vegas, April 2011 ist die Notwendigkeit bekannt, für CPV-Anwendungen hochreflektive Silberspiegel mit hoher Langlebigkeit zur Verfügung zu stellen. In diesem Zusammenhang werden verschiedene Lösungsansätze in allgemeiner Form vorgestellt. Dabei wurde unter anderem ein System vorgestellt, welches folgenden allgemeinen Aufbau besitzt: Substrat, Metall, Silberreflektor, Metalloxid, HMDSO.

In SVC/Society of Vacuum Coaters 2009, Optics 021 wird das Plasmacoating als einfache Methode zur Herstellung von metallischen reflektierenden und korrosionsbeständigen Mehrschichtsystemen beschrieben und Versuche durchgeführt. Es wird beschrieben, dass nach dieser Methode bislang keine Aluminiumoxidschutzschichten in den oben beschriebenen Kurztaktbeschichtungen eingesetzt werden.

In Surface and Coatings Technology 111 (1999) 278 - 296 werden Aluminium-Spiegel durch Integration von Pharma-Vorbehandlung, Sputtern und Plasma-Polymerization für die Autolampen-Produktion beschrieben.

Der in Fig 5 der Publikation Applied Optics Bd. 24, Nr. 8, 15. April 1985, Seiten 1164-1170 unterscheidet sich von der vorliegenden Erfindung (Alternative b), da er anstelle der vorliegend im Anspruch genannten Metalle (Titan, Gold, Palladium, Platin,

Vanadium, oder Tantal) Kupfer enthält. Es wird vielmehreine Untersuchung von Silber unterlegt mit Kupfer beschrieben.

Für die Anwendung von Reflektoren im CPV- und CSP-Bereich reicht das Eigenschaftsprofil der oben genannten Systeme jedoch insbesondere im Hinblick auf den Erhalt einer hohen Reflektivität während der Lebensdauer im Außeneinsatz nicht aus. Insbesondere ist nach wie vor die negative Beeinflussung der Reflektivität durch verstärkte witterungsbedingte Korrosion noch nicht zufriedenstellend für einen kommerziellen Einsatz gelöst. Weiterhin sollen diese Mehrschichtsysteme auf eine einfache und kostengünstige Weise in großer Stückzahl hergestellt werden können.

Aufgabe der vorliegenden Erfindung ist es daher, ein Mehrschichtsystem zur Verfügung zu stellen, welches über eine über den Lebenszyklus konstant hohe Reflektivität verfügt, wobei solche Mehrschichtkörper durch ein einfaches und kostengünstiges Verfahren herstellbar sind. Weiterhin soll das Mehrschichtsystem eine hohe Formstabilität, eine geringe Rissbildung sowie eine niedrige Oberflächenrauigkeit aufweisen und damit den Anforderungen der DIN EN 62108 bezüglich der Klimawechselstabilität (Kapitel 10.6, 10.7 und 10.8) genügt.Die Aufgabe wurde gelöst durch einen Mehrschichtaufbau enthaltend fünf Schichten:

Schicht A: eine Substratschicht, ausgewählt aus einem thermoplastischen Kunststoff, Metall oder Glas

Schicht B: eine Barriereschicht, ausgewählt aus Titan, Gold, Palladium, Platin, Vanadium oder Tantal, wobei im Falle von Glas als Substratschicht die Barriereschicht zusätzlich auch aus Chrom oder Legierungen aus Chrom mit Co, Mo, Ni und/oder Fe sein kann.

Schicht C: metallische Reflektorschicht, bevorzugt aus Silber oder Silberlegierungen, wobei die Silberlegierung Anteile von kleiner 10 Gew.-% an Gold, Platin, Palladium und/oder Titan aufweist, sowie Aluminium.

Schicht D: oxidische Schicht mit einer Schichtdicke von 80 nm bis 250 nm, ausgewählt aus Aluminiumoxid (AlOx), Titandioxid, $SiO_2$, $Ta_2O_5$, $ZrO_2$, $Nb_2O_5$ und HfO.

Schicht E:

a) Plasmapolymerschicht (Korrosionsschutzschicht) abgeschieden aus Siloxanprecusoren; beispielsweise und bevorzugt genannte sind Hexamethyldisiloxan (HMDSO), Octamethylcyclotetrasiloxan (OMCTS), Octamethyltrissiloxan (OMTS), Tetraethylorthosilan (TEOS), und Tetrametyldisiloxan (TMDSO), Decamethylcyclopentasiloxan (DMDMS), Hexamethylcyclotrisiloxan (HMCTS), Trimethoxymethylsilan (TMOMS), Tetramethylcyclotetrasiloxan (TMCTS); besonders bevorzugt ist HMDSO, oder im Falle, dass Schicht D aus Aluminiumoxid oder $SiO_2$ ist Schicht E

b) eine hochbrechende Metalloxidschicht, wobei die Metalloxide ausgewählt sind aus Titandioxid, $SiO_2$, $Ta_2O_5$, $ZrO_2$, $Nb_2O_5$ und HfO oder SiO2 sein kann und optional eine weitere Schicht gemäß Schicht E (a), also eine Plasmapolymerschicht aufgebracht sein kann.

Aus den Beispielen geht hervor, dass dieser Mehrschichtaufbau das geforderte Eigenschaftsprofil einer hohen Formstabilität, einer geringen Rissbildung sowie einer niedrigen Oberflächenrauigkeit aufweist und damit den Anforderungen der DIN EN 62108 bezüglich der Klimawechselstabilität (Kapitel 10.6, 10.7 und 10.8) genügt.

Schicht A:

Schicht A ist ausgewählt aus einem thermoplastischen Kunststoff, Metall oder Glas.

Thermoplastische Kunststoffe für die Substratschicht sind bevorzugt Polycarbonat, Polystyrol, Styrol-Copolymere, aromatische Polyester wie Polyethylenterephthalat (PET), PET-Cyclohexandimethanol-Copolymer (PETG), Polyethylennaphthalat (PEN), Polybutylenterephthalat (PBT), cyclisches Polyolefin, Poly- oder Copolyacrylate und Poly- oder Copolymethacrylat wie z.B. Poly- oder Copolymethylmethacrylate (wie PMMA) sowie Copolymere mit Styrol wie z.B. transparentes Polystyrolacrylnitril (PSAN), thermoplastische Polyurethane, Polymere auf Basis von zyklischen Olefinen (z.B. TOPAS®, ein Handelsprodukt der Firma Ticona), Polycarbonat Blends mit olefinischen Copolymeren oder Pfropfpolymeren, wie beispielsweise Styrol/Acrylnitril Copolymeren. Besonders bevorzugt ist Polycarbonat, PET oder PETG. Insbesondere ist die Substratschicht aus Polycarbonat.

Polycarbonate im Sinn der vorliegenden Erfindung sind sowohl Homopolycarbonate, Copolycarbonate als auch Polyestercarbonate wie sie beispielsweise EP-A 1,657,281 sind.

Die Herstellung aromatischer Polycarbonate erfolgt z. B. durch Umsetzung von Diphenolen mit Kohlensäurehalogeniden, vorzugsweise Phosgen und/oder mit aromatischen Dicarbonsäuredihalogeniden, vorzugsweise Benzoldicarbonsäuredihalogeniden, nach dem Phasengrenzflächenverfahren, gegebenenfalls unter Verwendung von Kettenabbrechern, beispielsweise Monophenolen und gegebenenfalls unter Verwendung von trifunktionellen oder mehr als trifunktionellen Verzweigern, beispielsweise Triphenolen oder Tetraphenolen. Ebenso ist eine Herstellung über ein Schmelzepolymerisationsverfahren durch Umsetzung von Diphenolen mit beispielsweise Diphenylcarbonat möglich.

Diphenole zur Herstellung der aromatischen Polycarbonate und/oder aromatischen Polyestercarbonate sind vorzugsweise solche der Formel (I)

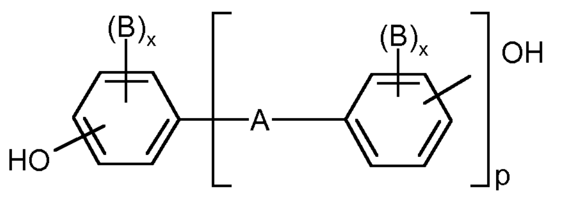

(I),

wobei

A eine Einfachbindung, $C_1$ bis $C_5$-Alkylen, $C_2$ bis $C_5$-Alkyliden, $C_5$ bis $C_6$-Cycloalkyliden, -O-, -SO-, -CO-, -S-, $-SO_2-$ $C_6$ bis $C_{12}$-Arylen, an das weitere aromatische gegebenenfalls Heteroatome enthaltende Ringe kondensiert sein können,

oder ein Rest der Formel (II) oder (III)

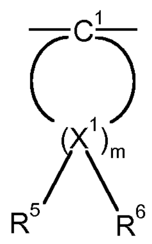

(II)

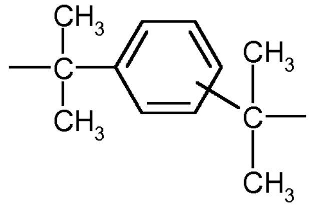

(III)

B jeweils $C_1$ bis $C_{12}$-Alkyl, vorzugsweise Methyl, Halogen, vorzugsweise Chlor und/oder Brom

x jeweils unabhängig voneinander 0, 1 oder 2,

p 1 oder 0 sind, und

$R^5$ und $R^6$ für jedes $X^1$ individuell wählbar, unabhängig voneinander Wasserstoff oder $C_1$ bis $C_6$-Alkyl, vorzugsweise Wasserstoff, Methyl oder Ethyl,

$X^1$ Kohlenstoff und

m eine ganze Zahl von 4 bis 7, bevorzugt 4 oder 5 bedeuten, mit der Maßgabe, dass an mindestens einem Atom $X^1$, $R^5$ und $R^6$ gleichzeitig Alkyl sind.

Für die Herstellung der Polycarbonate geeignete Diphenole sind beispielsweise Hydrochinon, Resorcin, Dihydroxydiphenyle, Bis-(hydroxyphenyl)-alkane, Bis(hydroxyphenyl)-cycloalkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, alpha-alpha'-Bis-(hydroxyphenyl)-diisopropylbenzole,Phtalimidine abgeleitet von Isatin- oder Phenolphthaleinderivaten sowie deren kernalkylierte und kernhalogenierte Verbindungen.

Bevorzugte Diphenole sind 4,4'-Dihydroxydiphenyl, 2,2-Bis-(4-hydroxyphenyl)-propan, 2,4-Bis-(4-hydroxyphenyl)-2-methylbutan, 1,1-Bis-(4-hdydroxyphenyl)-p-diisopropylbenzol, 2,2-Bis-(3-methyl-4-hydroxyphenyl)-propan, 2,2-Bis-(3-chlor-4-hydroxyphenyl)-propan, Bis-(3,5-dimethyl-4-hydroxyphenyl)-methan, 2,2-Bis-(3,5-dimethyl-4-hydroxyphenyl)-propan, Bis-(3,5-dimethyl-4-hydroxyphenyl)-sulfon, 2,4-Bis-(3,5-dimethyl-4-hydroxyphenyl)-2-methylbutan, 1,1-Bis-(3,5-dimethyl-4-hydroxyphenyl)-p-diisopropylbenzol, 2,2-Bis-(3,5-dichlor-4-hydroxyphenyl)-propan, 2,2-Bis-(3,5-dibrom-4-hydroxyphenyl)-propan, 1,1-Bis-(4-hydroxyphenyl)-3,3,5-trimethylcyclohexan, und 2-Hydrocarbyl-3,3-Bis(4-Hydroxyaryl)phthalimidine sowie dem Reaktionsprodukt von N-Phenylisatin und Phenol.

Besonders bevorzugte Diphenole sind 2,2-Bis-(4-hydroxyphenyl)-propan, 2,2-Bis-(3,5-dimethyl-4-hydroxyphenyl)-propan, 2,2-Bis-(3,5-dichlor-4-hydroxyphenyl)-propan, 2,2-Bis-(3,5-dibrom-4-hydroxyphenyl)-propan, 1,1-Bis-(4-hydroxyphenyl)-cyclohexan und 1, 1-Bis-(4-hydroxyphenyl)-3,3,5-trimethylcyclohexan.

Im Fall der Homopolycarbonate ist nur ein Diphenol eingesetzt, im Fall der Copolycarbonate sind mehrere Diphenole eingesetzt. Geeignete Kohlensäurederivate sind beispielsweise Phosgen oder Diphenylcarbonat.

Geeignete Kettenabbrecher, die bei der Herstellung der Polycarbonate eingesetzt werden können, sind sowohl Monophenole als auch Monocarbonsäuren. Geeignete Monophenole sind Phenol selbst, Alkylphenole wie Kresole, p-tert.-Butylphenol, Cumylphenol, p-n-Octylphenol, p-iso-Octylphenol, p-n-Nonylphenol und p-iso-Nonylphenol, Halogenphenole wie p-Chlorphenol, 2,4-Dichlorphenol, p-Bromphenol und 2,4,6-Tribromphenol, 2,4,6-Trijodphenol, p-Jodphenol, sowie deren Mischungen. Bevorzugte Kettenabbrecher sind Phenol, Cumylphenol und/oder p-tert.-Butylphenol.

Besonders bevorzugte Polycarbonate im Rahmen der vorliegenden Erfindung sind Homopolycarbonate auf Basis von Bisphenol A und Copolycarbonate auf Basis der Monomere ausgewählt aus mindestens einem der Gruppe aus Bisphenol A, 1,1-Bis-(4-hydroxyphenyl)- 3,3,5-trimethylcyclohexan, 2-Hydrocarbyl-3,3-Bis(4-Hydroxyaryl)phthalimidine und den Reaktionsprodukten aus N-Phenylisatin und Phenol. Die Polycarbonate können in bekannter Weise linear oder verzweigt sein. Der Anteil der Co-Monomere bezogen auf Bisphenol A beträgt im allgemeinen bis zu 60 Gew. %, bevorzugt bis zu 50 Gew-%, besonders bevorzugt 3 bis 30 Gew-%. Mischungen von Homopolycarbonat und Copolycarbonaten können ebenfalls verwendet werden.

Polycarbonate und Co-Polycarbonate enthaltend 2-Hydrocarbyl-3,3-Bis(4-Hydroxyaryl)phthalimidine als Monomere sind unter anderem bekannt aus EP 1 582 549 A1. Polycarbonate und Co-Polycarbonate enthaltend Bisphenolmonomere basierend auf Reaktionsprodukten aus N-Phenylisatin und Phenol sind beispielsweise in WO 2008/037364 A1 beschrieben.

Die thermoplastischen, aromatischen Polycarbonate haben mittlere Molekulargewichte (Gewichtsmittel $M_w$, gemessen durch GPC (Gelpermeationschromatographie mit Polycarbonatstandard) von 10.000 bis 80.000 g/mol, bevorzugt 14.000 bis 32.000 g/mol, besonders bevorzugt 18.000 bis 32.000 g/mol. Im Falle spritzgegossener Polycarbonat-Formteile beträgt das bevorzugte mittlere Molekulargewicht 20.000 bis 29.000 g/mol. Im Falle von extrudierten Polycarbonat-Formteilen beträgt das bevorzugte mittlere Molekulargewicht 25.000 bis 32.000 g/mol.

Die Polycarbonate können ferner Füllstoffe enthalten. Als Füllstoffes sind Glaskugeln, Glashohlkugeln, Glasflakes, Ruße, Graphite, Kohlenstoffnanoröhrchen, Quarze, Talk, Glimmer, Silikate, Nitride, Wollastonit, sowie pyrogene oder gefällte Kieselsäuren, wobei die Kieselsäuren BET-Oberflächen von mindestens 50 $m^2/g$ (nach DIN 66131/2) aufweisen, geeignet.

Bevorzugte faserförmige Füllstoffe sind metallische Fasern, Kohlenstofffasern, Kunststofffasern, Glasfasern oder gemahlene Glasfasern, besonders bevorzugt sind Glasfasern oder gemahlene Glasfasern. Bevorzugte Glasfasern sind auch solche, die in der Ausführungsform Endlosfaser (rovings), Langglasfasern und Schnittglasfasern verwendet werden, die aus M-, E-, A-, S-, R- oder C-Glas herstellt werden, wobei E-, A-, oder C-Glas weiter bevorzugt sind.

Der Durchmesser der Fasern beträgt bevorzugt 5 bis 25 $\mu$m, weiter bevorzugt 6 bis 20 $\mu$m, besonders bevorzugt 7 bis 15 $\mu$m. Langglasfasern weisen bevorzugt eine Länge von 5 bis 50 mm, weiter bevorzugt von 5 bis 30 mm, noch weiter bevorzugt von 6 bis 15mm, und besonders bevorzugt von 7 bis 12 mm auf; sie werden beispielsweise in WO-A 2006/040087 beschrieben. Die Schnittglasfasern weisen bevorzugt zu mindestens 70 Gew.% der Glasfasern eine Länge von mehr als 60 $\mu$m auf.

Weitere anorganischen Füllstoffe sind anorganische Partikel mit Korngestalt ausgewählt aus der Gruppe, die sphärische / kubische, tabular / diskusförmige und plattiger Geometrien umfasst. Insbesondere geeignet sind anorganische Füllstoffe mit sphärischer oder plattiger, bevorzugt in feinteiliger und/oder poröser Form mit großer äußerer und/oder innerer Oberfläche. Dabei handelt es sich bevorzugt um thermisch inerte anorganische Materialien insbesondere basierend auf Nitride wie Bornitrid, um Oxide oder Mischoxide wie Ceroxid, Alumimiumoxid, um Carbide wie Wolframcarbid, Siliciumcarbid oder Borcarbid gepulvertem Quarz wie Quarzmehl, amorphes $SiO_2$, gemahlener Sand, Glaspartikel wie Glaspulver, insbesondere Glaskugeln, Silikate oder Alumosilikate, Graphit, insbesondere hochreiner synthetischer Graphit. Insbesondere bevorzugt sind dabei Quarz und Talk, am stärksten bevorzugt Quarz (sphärische Korngestalt). Diese Füllstoffe sind durch einen mittleren Durchmesser $d_{50\%}$ von 0,1 bis 10 $\mu$m, vorzugsweise von 0.2 bis 8.0 $\mu$m, weiter bevorzugt von 0.5 bis 5 $\mu$m, gekennzeichnet.

Silikate sind durch einen mittleren Durchmesser $d_{50\%}$ von 2 bis 10 $\mu$m, vorzugsweise von 2.5 bis 8.0 $\mu$m, weiter bevorzugt von 3 bis 5 $\mu$m, und besonders bevorzugt von 3 $\mu$m, gekennzeichnet, wobei ein oberer Durchmesser $d_{95\%}$ von entsprechend 6 bis 34 $\mu$m, weiter bevorzugt von 6.5 bis 25.0 $\mu$m, noch weiter bevorzugt von 7 bis 15 $\mu$m, und besonders bevorzugt von 10 $\mu$m bevorzugt ist. Bevorzugt weisen die Silikate eine spezifische BET-Oberfläche, bestimmt durch Stickstoffadsorption gemäß ISO 9277, von 0.4 bis 8.0 $m^2/g$, weiter bevorzugt von 2 bis 6 $m^2/g$, und besonders bevorzugt von 4.4 bis 5.0 $m^2/g$ auf.

Weiter bevorzugte Silikate weisen nur maximal 3 Gew.-% Nebenbestandteile auf, wobei vorzugsweise der Gehalt an

$$Al_2O_3 < 2.0 \text{ Gew.\%},$$

$$Fe_2O_3 < 0.05 \text{ Gew.\%},$$

$$(CaO + MgO) < 0.1 \text{ Gew.\%},$$

$$(Na_2O + K_2O) < 0.1 \text{ Gew.\%})$$

ist, jeweils bezogen auf das Gesamtgewicht des Silikats.

Eine weitere vorteilhafte Ausführungsform verwendet Wollastonit oder Talk in Form von feinvermahlenen Typen mit einem mittleren Partikeldurchmesser $d_{50}$ von <10 μm, bevorzugt <5 μm, besonders bevorzugt <2 μm, ganz besonders bevorzugt <1,5 μm. Die Korngrößenverteilung wird durch Windsichten bestimmt.

Die Silikate können eine Beschichtung mit silicium-organischen Verbindungen haben, wobei bevorzugt Epoxysilan-, Methylsiloxan-, und Methacrylsilan-Schlichten zum Einsatz kommen. Besonders bevorzugt ist eine Epoxysilanschlichte.

Die Füllstoffe können in einer Menge bis zu 40 Gew.% bezogen auf die Menge an Polycarbonat zugesetzt werden. Bevorzugt sind 2,0 bis 40,0 Gew.-%, bevorzugt 3,0 bis 30,0 Gew.-%, weiter bevorzugt 5,0 bis 20,0 Gew.-%, und besonders bevorzugt 7,0 bis 14,0 Gew.-%.

Als Blendpartner für Polycarbonate sind Pfropfpolymerisate von Vinylmonomeren auf Pfropfgrundlagen wie Dienkautuschke oder Acrylatkautschuke geeignet. Pfropfpolymerisate B sind bevorzugt solche aus

B.1 5 bis 95, vorzugsweise 30 bis 90 Gew.-%, wenigstens eines Vinylmonomeren auf B.2 95 bis 5, vorzugsweise 70 bis 10 Gew.-% einer oder mehrerer Pfropfgrundlagen mit Glasübergangstemperaturen < 10°C, vorzugsweise < 0°C, besonders bevorzugt <-20°C.

Die Pfropfgrundlage B.2 hat im allgemeinen eine mittlere Teilchengröße ($d_{50}$-Wert) von 0,05 bis 10 μm, vorzugsweise 0,1 bis 5 μm, besonders bevorzugt 0,2 bis 1 μm.

Monomere B.1 sind vorzugsweise Gemische aus

B.1.1 50 bis 99 Gew.-Teilen Vinylaromaten und/oder kernsubstituierten Vinylaromaten (wie Styrol, α-Methylstyrol, p-Methylstyrol, p-Chlorstyrol) und/oder Methacrylsäure-($C_1$-$C_8$)-Alkylester, wie Methylmethacrylat, Ethylmethacrylat), und

B.1.2 1 bis 50 Gew.-Teilen Vinylcyanide (ungesättigte Nitrile wie Acrylnitril und Methacrylnitril) und/oder (Meth)Acrylsäure-($C_1$-$C_8$)-Alkylester, wie Methylmethacrylat, n-Butylacrylat, t-Butylacrylat, und/oder Derivate (wie Anhydride und Imide) ungesättigter Carbonsäuren, beispielsweise Maleinsäureanhydrid und N-Phenyl-Maleinimid.

Bevorzugte Monomere B.1.1 sind ausgewählt aus mindestens einem der Monomere Styrol, α-Methylstyrol und Methylmethacrylat, bevorzugte Monomere B.1.2 sind ausgewählt aus mindestens einem der Monomere Acrylnitril, Maleinsäureanhydrid und Methylmethacrylat. Besonders bevorzugte Monomere sind B.1.1 Styrol und B.1.2 Acrylnitril.

Für die Pfropfpolymerisate B geeignete Pfropfgrundlagen B.2 sind beispielsweise Dienkautschuke, EP(D)M-Kautschuke, also solche auf Basis Ethylen/Propylen und gegebenenfalls Dien, Acrylat-, Polyurethan-, Silikon-, Chloropren und Ethylen/Vinylacetat-Kautschuke.

Bevorzugte Pfropfgrundlagen B.2 sind Dienkautschuke, beispielsweise auf Basis Butadien und Isopren, oder Gemische von Dienkautschuken oder Copolymerisate von Dienkautschuken oder deren Gemischen mit weiteren copolymerisierbaren Monomeren (z.B. gemäß B.1.1 und B.1.2), mit der Maßgabe, dass die Glasübergangstemperatur der Komponente B.2 unterhalb < 10°C, vorzugsweise < 0°C, besonders bevorzugt < -10°C liegt. Besonders bevorzugt ist reiner Polybutadienkautschuk.

Besonders bevorzugte Polymerisate B sind beispielsweise ABS-Polymerisate (Emulsions-, Masse- und Suspensions-ABS), wie sie z.B. in der DE-OS 2 035 390 (=US-PS 3 644 574) oder in der DE-OS 2 248 242 (=GB-PS 1 409 275) bzw. in Ullmanns, Enzyklopädie der Technischen Chemie, Bd. 19 (1980), S. 280 ff. beschrieben sind. Der Gelanteil der Pfropfgrundlage B.2 beträgt mindestens 30 Gew.-%, vorzugsweise mindestens 40 Gew.-% (in Toluol gemessen).

Die Pfropfcopolymerisate B werden durch radikalische Polymerisation, z.B. durch Emulsions-, Suspensions-, Lösungs- oder Massepolymerisation, vorzugsweise durch Emulsions- oder Massepolymerisation hergestellt.

Da bei der Pfropfreaktion die Pfropfmonomeren bekanntlich nicht unbedingt vollständig auf die Pfropfgrundlage aufgepfropft werden, werden erfindungsgemäß unter Pfropfpolymerisaten B auch solche Produkte verstanden, die durch (Co)Polymerisation der Pfropfmonomere in Gegenwart der Pfropfgrundlage gewonnen werden und bei der Aufarbeitung mit anfallen.

Die Polymer-Zusammensetzungen können optional noch weitere übliche Polymeradditive enthalten, wie z.B. die in EP-A 0 839 623, WO-A 96/15102, EP-A 0 500 496 oder "Plastics Additives Handbook", Hans Zweifel, 5th Edition 2000, Hanser Verlag, München) beschriebenen Antioxidantien, Thermostabilisatoren, Entformungsmittel, optischen Aufheller, UV Absorber und Lichtstreumittel in den für die jeweiligen Thermoplasten üblichen Mengen.

Als UV-Stabilisatoren sind Benzotriazole, Triazine, Benzophenone und/oder arylierte Cyanoacrylate geeignet. Besonders geeignete UV-Absorber sind Hydroxy-Benzotriazole, wie 2-(3',5'-Bis-(1,1-dimethylbenzyl)-2'-hydroxy-phenyl)-benzotriazol (Tinuvin® 234, Ciba Spezialitätenchemie, Basel), 2-(2'-Hydroxy-5'-(tert.-octyl)-phenyl)-benzotriazol (Tinuvin® 329, Ciba Spezialitätenchemie, Basel), 2-(2'-Hydroxy-3'-(2-butyl)-5'-(tert.butyl)-phenyl)-benzotriazol (Tinuvin® 350, Ciba Spezialitätenchemie, Basel), Bis-(3-(2H-benztriazolyl)-2-hydroxy-5-tert.-octyl)methan, (Tinuvin® 360, Ciba Spezialitätenchemie, Basel), (2-(4,6-Diphenyl-1,3,5-triazin-2-yl)-5-(hexyloxy)-phenol (Tinuvin® 1577, Ciba Spezialitätenchemie, Basel), sowie der Benzophenone 2,4-Dihydroxy-benzophenon (Chimasorb® 22, Ciba Spezialitätenchemie, Basel) und 2-Hydroxy-4-(octyloxy)-benzophenon (Chimassorb® 81, Ciba, Basel), 2-Propenoic acid, 2-Cyano-3,3-diphenyl-, 2,2-Bis[[(2-cyano-1-oxo-3,3-diphenyl-2-propenyl)oxy]-methyl]-1,3-propanediylester (9Cl) (Uvinul® 3030, BASF AG Ludwigshafen), 2-[2-Hydroxy-4-(2-ethylhexyl)oxy]phenyl-4,6-di(4-phenyl)phenyl-1,3,5-triazine (CGXUVA 006, Ciba Spezialitätenchemie, Basel) oder Tetra-ethyl-2,2'-(1,4-phenylene-dimethylidene)-bismalonate (Hostavin® B-Cap, Clariant AG).

Die Polymer-Zusammensetzung kann UV-Absorber üblicherweise in einer Menge von 0 bis 5 Gew.%, bevorzugt 0,1 bis 2,5 Gew.% bezogen auf die Gesamtzusammensetzung enthalten.

Die Herstellung der Polymer-Zusammensetzungen erfolgt mit gängigen Einarbeitungsverfahren durch Zusammenführung, Vermischen und Homogenisieren der einzelnen Bestandteile, wobei insbesondere die Homogenisierung bevorzugt in der Schmelze unter Einwirkung von Scherkräften stattfindet. Gegebenenfalls erfolgt das Zusammenführen und Vermischen vor der Schmelzehomogenisierung unter Verwendung von Pulvervormischungen.

Das Substratmaterial kann als Folie oder Platte vorliegen. Die Folie kann verformt und mit einem weiteren Thermoplasten aus den oben genannten Thermoplasten hinterspritzt werden (Film Insert Molding (FIM)). Platten können thermogeformt oder mittels Drape-Forming bearbeitet bzw. kalt eingebogen werden. Auch ist eine Formgebung über Spritzguss-Prozesse möglich. Diese Prozesse sind dem Fachmann bekannt.

Die Dicke der Substratschicht muss hierbei so beschaffen sein, dass im Bauteil eine hinreichende Steifigkeit gewährleistet ist.

Im Falle einer Folie kann die Substratschicht A durch Hinterspritzen verstärkt werden, um eine ausreichende Steifigkeit zu gewährleisten.

Die Gesamtdicke der Schicht A, d.h. einschließlich einer möglichen Hinterspritzung, beträgt im allgemeinen 1 µm - 10 mm. Besonders bevorzugt beträgt die Dicke der Schicht A) 1 mm - 10 mm, 1 mm - 5 mm, 2 mm - 4 mm. Insbesondere beziehen sich die Dickenangaben auf die Gesamtsubstratdicke bei Verwendung von Polycarbonat als Substratmaterial einschließlich einer möglichen Hinterspritzung.

Bei PET beträgt die Schichtdicke vorzugsweise 10µm - 100 µm (PET), die Dicker einer PC-Folie beträgt bevorzugt 100 µm - 1mm (PC-Folie), wobei durch Hinterspritzung diese Thermoplasten verstärkt werden können.

Bei metallischen Substraten beträgt die Schichtdicke im allgeminen 300 µm - 750 µm Bei Glassubstraten beträgt die Schichtdicke im allgemeinen 750 µm - 3 mm, bevorzugt 800 µm - 2 mm.

**Schicht B:**

Schicht B ist ausgewählt aus den oben genannten Metallen. Schicht B ist bevorzugt frei von Kupfer oder Kupfer haltigen Verbindungen bzw. Kupfer haltigen Legierungen.

Die Dicke der Schicht B beträgt im allgemeinen 40 nm - 250 nm, bevorzugt 55 nm - 200 nm und insbesondere 80 nm - 130 nm.

Die besonders bevorzugte Schichtdicke bei Verwendung von Titan liegt im Bereich von 105 nm-120 nm.

**Schicht C:**

Die Dicke der Schicht C beträgt im allgemeinen 80 nm - 250 nm, bevorzugt 90 nm - 160 nm und besonders bevorzugt 100 nm - 130 nm.

Im Falle von Silber wird hochreines Silber eingesetzt. Kommerziell verfügbare Produkte sind bei Heraeus Precious Metals (z.B: Target Ag Reinheit 3N7) oder Umicore erhältlich.

**Schicht D:**

Die Dicke der Schicht D beträgt 80 nm - 250 nm, bevorzugt 90 nm - 160 nm, besonders bevorzugt 90 nm - 130 nm und ganz besonders bevorzugt 90 nm - 110 nm.

**Schicht E:**

Die Dicke der Schicht E beträgt im allgemeinen 1 nm - 200 nm, bevorzugt 10 nm - 150 nm, besonders bevorzugt 20 nm- 100 nm und ganz besonders bevorzugt 30 nm - 50 nm.

**Aufbringen der Schichten:**

Die Schichten B und C werden jeweils durch Aufdampfen oder durch Sputtern aufgebracht. Die Schicht D wird reaktiv aufgedampft oder reaktiv gesputtert mit Sauerstoff als Reaktivgas. Diese Verfahren sind allgemein bekannt und zum Beispiel beschrieben in Vakuumbeschichtung, Band 1-5, Hrsg. Hartmut Frey, VDI Verlag, 1995.

Der Auftrag von Metallen auf das Polymer kann über verschiedene Methoden wie z.B. durch Aufdampfen oder Sputtern geschehen. Die Verfahren sind näher beschrieben z.B. in "Vakuumbeschichtung Bd.1 bis 5", H. Frey, VDI-Verlag Düsseldorf 1995 oder "Oberflächen- und Dünnschicht-Technologie" Teil 1, R.A. Haefer, Springer Verlag 1987.

Um eine bessere Metallhaftung zu erreichen und um die Substratoberfläche zu reinigen, werden die Substrate normalerweise einer Plasmavorbehandlung unterzogen. Eine Plasmavorbehandlung kann u. U. die Oberflächeneigenschaften von Polymeren verändern. Diese Methoden sind z.B. bei Friedrich et al. in Metallized plastics 5 & 6: Fundamental and applied aspects und H. Grünwald et al. in Surface and Coatings Technology 111 (1999) 287-296 beschrieben.

Die Schicht E wird in einem PECVD (plasma enhanced chemical vapour deposition) oder Plasmapolymerisationsprozess aufgebracht. Hierbei werden niedrigsiedende Precursoren haupsächlich auf Siloxan-Basis in ein Plasma verdampft und dadurch aktiviert, so dass sie einen Film bilden können. Das Verfahren ist unter anderem beschrieben in Surface and Coatings Technology 111 (1999), 287-296.

Weitere Funktionsschichten z.B. gegen mechanische Beanspruchung und/oder reflexionserhöhende Schichten basieren auf hochbrechenden Metalloxiden (z.B. TiO2) können aufgebracht werden. Solche Schichten sind beispielhaft in WO 2010/127805 und WO2010/085909 beschrieben.

Der erfindungsgemäße Mehrschichtaufbaus kann als Reflektor für Photovoltaikmodule (Concentrating Photovoltaics) und Solarmodule (Concentrating Solar Power), Beleuchtungssysteme, als Spiegel im Wohnbereich sowie im Fahrzeugbereich (z.B. Luft-und Schienenfahrzeuge, Busse, Nutzfahrzeuge und Kfz), Reflektoren in Lichtleitsystemen verwendet werden. Gegenstand der vorliegenden Erfindung sind daher auch Photovoltaikmodule und Solarmodule, Beleuchtungssysteme enthaltend einen erfindungsgemäßen Mehrschichtaufbau.

Die Erfindung wird durch die folgenden Beispiele näher erläutert ohne auf diese beschränkt zu sein. Die erfindunsgemäßen Beispiele geben lediglich bevorzugte Ausführungsformen der vorliegenden Erfindung wieder.

**Beispiele:**

**Herstellung der Schicht A**

Platte (105x150x3.2 mm) aus Polycarbonat auf Basis Bisphenol A:

PC-1: Makrolon® 2407, Bayer MaterialScience AG, Leverkusen, Deutschland, mit einer Schmelze-Volumenfließrate (MVR) von 19 $cm^3$/10min, gemessen nach ISO 1133 bei 300 und 1,2 kg.
PC-2: Makrolon® 2808, Bayer MaterialScience AG, Leverkusen, Deutschland, mit einer Schmelze-Volumenfließrate (MVR) von 9 $cm^3$/10min, gemessen nach ISO 1133 bei 300 und 1,2 kg.

**Herstellung der Platte:**

Es wurden Spritzguss-Rechteckplatten mit den Maßen 150 x 105 x 3,2 mm mit Seitenanguss angefertigt. Die Massetemperatur betrug 300 - 330°C und die Werkzeugtemperatur 100°C. Das jeweilige Granulat wurde vor Verarbeitung für 5 Stunden im Vakuumtrockenschrank bei 120°C getrocknet.

**Bestimmung der Rauigkeit der Schicht A**

Aufgrund der konzentrierenden Optik ist der Wirkungsgrad des gesamten Systems stark abhängig vom Streulicht. Eine Voraussetzung das auftretende Streulicht zu minimieren sind glatte Substratoberflächen. An denen im Spritzguss abgeformten Oberflächen wurde die Rauigkeit bestimmt. Als ein Maß für die Rauigkeit wurde der $R_a$ (mittlere Rauigkeit) verwendet. Die Werte wurden an verschieden großen Messfeldern an unbeschichteten Platten mit den folgenden Methoden gemessen, um die Rauigkeit auf größeren Flächen nachweisen zu können:

- AFM (atomic force microscopy):
  - o Größe des untersuchten Messfelds: 5μmx5μm
  - o Größe des untersuchten Messfelds: 20μmx20μm

- WLI (white light interferometry)
    - o Größe des untersuchten Messfelds: 100µmx100µm

| **Material** | **Farbe** | **AFM** | | **WLI** |
|---|---|---|---|---|
| Messfeld | | 5µmx5µm | 20µmx20µm | 100µmx100µm |
| PC-1 | schwarz | 1.2 nm | 3.0 nm | 4.11 nm |
| PC-1 | transparent | 1.6 nm | 3.4 nm | 4.27 nm |

Die Rauigkeit Ra ist kleiner 5nm, so dass sehr glatte Oberflächen vorliegen.

**Schicht B:**

Als Schicht B wurden die folgenden Metalle verwendet:

Titan (erfindungsgemäß), alternativ Kupfer und Aluminium (beides Vergleichsbeispiele).

Es wurden Versuche durchgeführt, um die Eignung bestimmter Metalle zur Herstellung der Schicht B festzustellen. Die Herstellung der in der nachfolgenden Tabelle 1 beschriebenen Mehrschichtaufbauten erfolgte analog der Beschreibung für das Beispiel 1.

Tabelle 1:

| | Probe A | Probe B | Probe C |
|---|---|---|---|
| Schicht E/Dicke | HMDSO 40nm | HMDSO 40nm | HMDSO 40nm |
| Schicht C/Dicke | Ag 110nm | Ag 110nm | Ag 110nm |
| Schicht B/Dicke | Al 60nm | Ti 100hm | Cu 160nm |
| Schicht A/Dicke | PC-2 | PC-2 | PC-2 |

Die Proben wurden zur Beurteilung der Korrosionsbeständigkeit für 10 Tage bei 45°C und 100% relativer Feuchte gelagert und dann mit dem Auge optisch abgemustert. Ergebnisse:

- Probe A: Silberschicht wurde weißlich und schälte sich teilweise ab.
- Probe B: keine sichtbaren Defekte
- Probe C: Silberschicht verfärbte sich golden, Interdiffusion von Silber und Kupfer

Die Auswertung zeigt, dass sich Kupfer als Material für die Schicht B aufgrund der überraschend schlechten Korrosionsbeständigkeit nicht eignet. Daher wurden im Rahmen der vorliegenden Erfindung keine weiteren Versuche an Mehrschichtsystemen enthaltend Kupfer durchgeführt.

**Beispiel 1: Mehrschichtaufbau - erfindungsgemäß**

Die PC-Platte (PC-1)wurde beschichtet gemäß nachfolgender Beschreibung. Folgender Schichtaufbau wurde realisiert:

3,2 mm Substrat\\110nm Ti\\120nm Ag\\100nm AlOx\\40nm HMDSO

Herstellungsverfahren:

1. Die PC-Platte wurde in die Vakuumkammer eingeschleust und bis auf p< $2\cdot10^{-5}$ mbar evakuiert.
2. Plasmavorbehandlung: Die PC-Platte wurde 1 min bei 500W und 0,1 mbar Ar im Mittelfrequenz-Plasma (40kHz)

vorbehandelt.

3. Schicht B: Die Titan-Schicht wurde mittels DC sputtern abgeschieden. Als Beschichtungsquelle wurde ein rundes Planarmagnetron ION'X-8"HV von Thin Film Consulting mit einem Durchmesser von 200mm verwendet, die mit einem Generator "Pinnacle™ Plus+ 5kW" von Advanced Energy betrieben wurde. Zuerst wurde das Target (hier: Titan) bei geschlossener Blende für 1min freigesputtert und dann bei offener Blende innerhalb von 3min 40s mit 2000W und einem Druck von p= $5 \cdot 10^{-3}$ mbar die Titanschicht auf der PC-Platte abgeschieden.

4. Schicht C: Die Silber-Schicht wurde mittels DC sputtern abgeschieden. Als Beschichtungsquelle wurde ein rundes Planarmagnetron ION'X-8"HV von Thin Film Consulting mit einem Durchmesser von 200mm verwendet, die mit einem Generator "Pinnacle™ Plus+ 5kW" von Advanced Energy betrieben wurde. Zuerst wurde das Target (hier: Silber) bei geschlossener Blende für 1min freigesputtert und dann bei offener Blende innerhalb von 51s mit 2000W und einem Druck von p= $5 \cdot 10^{-3}$ mbar die Silberschicht auf der Titanschicht abgeschieden.

Danach wurde die beschichtete PC-Platte aus der Beschichtungsanlage entnommen und die Beschichtungsanlage für die letzten Schichten vorbereitet.

5. Die beschichtete PC-Platte wurde wieder in die Vakuumkammer eingeschleust und bis auf p< $2 \cdot 10^{-5}$ mbar evakuiert.

6. Plasmavorbehandlung: die beschichtete PC-Platte wurde 1 min bei 500W und 0,1 mbar Ar im Mittelfrequenz-Plasma (40kHz) vorbehandelt.

7. Schicht D: Die $AlO_x$-Schicht wurde mittels reaktiv, gepulstem DC sputtern mit einer Pulsfrequenz von 150 kHz abgeschieden. Als Beschichtungsquelle wurde ein rundes Planarmagnetron ION'X-8"HV von Thin Film Consulting mit einem Durchmesser von 200mm verwendet, die mit einem Generator Advanced Energy "Pinnacle™ Plus+ 5kW" betrieben wurde. Zuerst wurde das Target (hier: Aluminium) bei geschlossener Blende für 1min freigesputtert und dann bei offener Blende innerhalb von 4min bei 340V im spannungsgeregeltem Mode und einem Gesamtdruck von p= $5 \cdot 10^{-3}$ mbar die $AlO_x$-Schicht auf der Silberschicht abgeschieden. Das $O_2$/Ar-Verhältn wurde auf 8% eingestellt.

8. Schicht E: Mittels Plasmapolymerisation wurde HMDSO (Hexamethyldisiloxan) auf die AlOx-Schicht als weitere Schutzschicht aufgebracht. Die Schicht wurde bei einem Anfangsdruck von p=0.038 mbar und Fluss von 90sscm HMDSO und 1500W Mittelfrequenzleistung (40kHz) während 35s aufgebracht. Als Quelle wurde eine Parallelreaktoreinheit verwendet mit einem Plattenabstand von ca. 200mm, wobei sich die Platte in der Mitte befand. Die Quelle wurde mit einem Advanced Energy PEII (5kW) inkl. Hochspannungstrafo LMII betrieben.

Die Platte wurde während allen Beschichtungsschritten über die Beschichtungsquellen mit ca. 20rpm rotiert, um die Homogenität der Beschichtung zu erhöhen.

**Beispiel 2: Vergleichsbeispiel ohne HMDSO**

Die PC-Platte (PC-1) wurde mit folgendem Schichtaufbau analog Beispiel 1 beschichtet, wobei jedoch keine Beschichtung mit HDMSO erfolgte:

3,2 mm Substrat\\110nm Ti\\120nm Ag\\100nm AlOx

Die Proben bzw. die Platte wurden während allen Beschichtungsschritten über die Quellen mit ca. 20rpm rotiert, um die Homogenität der Beschichtung zu erhöhen.

**Beispiel 3: Vergleichsbeispiel**

In der Schicht C wurde statt Silber Aluminium verwendet.

Die PC-Platte (PC-1) wird wie folgt beschichtet:

3,2 mm Substrat\\ca. 100nm Al\\ca. 40nm HMDSO

Herstellungsverfahren:

1. PC-Platte wurde in die Vakuumkammer eingeschleust und bis auf p< $2.10^{-5}$ mbar evakuiert.

2. Plasmavorbehandlung: PC-Platte wurde 1 min bei 500W und 0,1 mbar Ar im Mittelfrequenz-Plasma (40kHz) vorbehandelt.

3. Schicht C: Die Aluminium-Schicht wurde mittels DC sputtern abgeschieden. Als Beschichtungsquelle wurde ein rundes Planarmagnetron ION'X-8"HV von Thin Film Consulting mit einem Durchmesser von 200mm verwendet,

die mit einem Generator "Pinnacle™ Plus+ 5kW" von Advanced Energy betrieben wurde. Zuerst wurde das Target (hier: Aluminium) bei geschlossener Blende für 2min freigesputtert und dann bei offener Blende innerhalb von 150s mit 2000W und einem Druck von p= $5 \cdot 10^{-3}$ mbar die Al-Schicht abgeschieden.

4. Schicht E: Mittels Plasmapolymerisation wurde HMDSO (Hexamethyldisiloxan) auf die Al-Schicht als Schutzschicht aufgebracht. Die Schicht wurde bei einem Anfangsdruck von p=0.038 mbar und Fluss von 90sscm HMDSO und 1500W Mittelfrequenzleistung (40kHz) während 35s aufgebracht. Als Quelle wurde eine Parallelreaktoreinheit verwendet mit einem Plattenabstand von ca. 200mm, wobei sich die Probe/Platte in der Mitte befand. Die Beschichtungsquelle wurde mit einem Advanced Energy PEII (5kW) inkl. Hochspannungstrafo LMII betrieben.

Die Proben bzw. die Platte wurden während allen Beschichtungsschritten über die Beschichtungsquellen mit ca. 20rpm rotiert, um die Homogenität der Beschichtung zu erhöhen.

**Einstellung der Schichtdicken:**

Zur Einstellung der Schichtdicken erfolgte zunächst eine Kalibrierung der Prozessparameter. Hierzu wurden unterschiedliche Schichtdicken bei definierten Prozessparametern auf einen Objektträger abgeschieden, der zur Erzeugung einer Stufe in der Mitte mit einem Klebestreifen versehen wurde. Nach Abscheidung der jeweiligen Schicht wurde der Klebestreifen entfernt und die Höhe der entstandenen Stufe mit einem Stufenabtaster KLA Tencor Alpha-Step 500 Surface Profiler von Tencor Instruments bestimmt.

Hierdurch werden Prozessparameter ermittelt, die für die Herstellung der gewünschten Zielschichtdicke eingestellt werden müssen.

**Messung der Schichtdicke am Fertigteil:**

Am Fertigteil lässt sich die Schichtdicke mittels TOF-SIMS (Time of Flight - Secondary Ion Mass Spectrometry) oder mit XPS (X-ray Photospectroscopy) in Kombination mit TEM (Transmission Electron Microscopy) bestimmen.

**Bewitterungsergebnisse:**

**Tabelle 2: Test- und Auswertemethoden:**

| **Prüfung** | **Bedingungen** | Zeit **(h)** | **Beurteilung** |
|---|---|---|---|
| Klimawechsel-Test (DIN EN 62108 10.6 & 10.8) | 100 Zyklen von -40°C bis 110°C (14 Zyklen pro Tag) gefolgt von 20 Zyklen Feuchte-Frost-Test (20h bei 85°C/85% relative Feuchte gefolgt von 4h Abkühlung auf -40°C und danach wieder aufheizen auf 85°C/85% relative Feuchte) | Ca. 650h | Bestimmung von RI |
| Xenon-T est | 0,75W/m$^2$/nm bei 340nm, Boro-Boro Filter, Schwarztafeltemperatur 70°C, 50% relative Feuchte, ohne Beregnung | 1000h | Bestimmung von RI |
| Damp Heat Test (DIN EN 62108 10.7) | 85°C, 85% relative Feuchte | 1000h | Bestimmung von RI |
| Dry Heat Test | Im Umlufttrockenschrank bei 125°C | 1000h | Bestimmung von RI |

Bestimmung von RI (Reflexions-Index):

1. Bestimmung von totalem ($R_{total}$) und diffusem ($R_{diffus}$) Reflexionsgrad mittels Photospektrometer Perkin Elmer Lambda 900, kalibriert auf Spektralon-Standard im Bereich von $\lambda$= 200-1100nm
2. Berechnung der direkten Reflexion: $R_{direkt} = R_{total} - R_{diffus}$
3. Berechnung von $RI_i = \frac{1}{Norm} \sum_i R_{direct}(\lambda) \cdot EQE_i(\lambda) \cdot SP(\lambda)$ mit $i$=1,2,3
4. Wobei *RI = min (RI$_i$)* mit *i = 1,2.*

EQE$_i$($\lambda$) (External Quantum Efficiency): z.B. Spectrolab C1MJ

SP(λ) : Sonnenspektrum nach ASTM G173-03

Tabelle 3: Folgende Proben wurden bewittert:

| Schichten | Beispiel 1 (erfindungsgemäß) | Beispiel 2 (Vergleich) | Beispiel 3 (Vergleich) |
|---|---|---|---|
| Schicht E | 40nm HMDSO | | 40nm HMDSO |
| Schicht D | 100nm AlOx | 100nm AlOx | |
| Schicht C | 120nm Ag | 120nm Ag | 100nm Al |
| Schicht B | 110nm Ti | 110nm Ti | |
| Schicht A | PC-1 | PC-1 | PC-1 |

Tabelle 4: Direkter Reflexionsgrad und RI - Ausgangswerte:

| $R_{direkt}$ | RI | 400nm | 500nm | 700nm | 900nm |
|---|---|---|---|---|---|
| Bsp.1 | 95,9% | 88,0% | 96,6% | 96,2% | 95,7% |
| Bsp.2 | 92,7% | 84,0% | 93,2% | 93,9% | 95,1% |
| Bsp.3 | 83,4% | 79,5% | 83,2% | 83,8% | 86,6% |

Tabelle 5: RI nach der Bewitterung:

| RI | Klimawechsel Test | Xenon Test (nach 1000h!) | Damp Heat Test | Dry Hot Test |
|---|---|---|---|---|
| Bsp.1 | 95,1% | 95,0% | 95,6% | 96,8% |
| Bsp.2 | 89,0% | 92,1% | 60,0% | 94,0% |
| Bsp.3 | 1% | 82,3% | 0,0% | 84,6% |

Die Schichten aus Beispiel 2 und 3 (Vergleich) zeigen in der Bewitterung unbefriedigendes Verhalten, während die Schichten aus Beispiel 1 (erfindungsgemäß) den Anforderungen genügen, um die geforderte Anforderung an die Langlebigkeit der hohen Reflektivität zu erfüllen.

**Patentansprüche**

**1.** Ein Mehrschichtaufbau, enthaltend fünf Schichten

Schicht A: eine Substratschicht, ausgewählt aus einem thermoplastischen Kunststoff, Metall oder Glas,
Schicht B: eine Barriereschicht, ausgewählt aus Titan, Gold, Palladium, Platin, Vanadium oder Tantal, wobei im Falle von Glas als Substratschicht die Barriereschicht zussätzlich auch aus Chrom oder Legierungen aus Chrom mit Co, Mo, Ni und/oder Fe sein kann.
Schicht C: metallische Reflektorschicht,
Schicht D: oxidische Schicht mit einer Dicke von 80 nm - 250 nm, ausgewählt aus Aluminiumoxid (AlOx), Titandioxid, SiO2, Ta2O5, ZrO2, Nb2O5 und HfO.
Schicht E:

a) Plasmapolymerschicht (Korrosionsschutzschicht) abgeschieden aus Siloxanprecusoren ausgewählt aus Hexamethyldisiloxan (HMDSO), Octamethylcyclotetrasiloxan (OMCTS), Octamethyltrissiloxan (OMTS), Tetraethylorthosilan (TEOS), und Tetrametyldisiloxan (TMDSO), Decamethylcyclopentasiloxan (DMDMS), Hexamethylcyclotrisiloxan (HMCTS), Trimethoxymethylsilan (TMOMS) und Tetramethylcyclotetrasiloxan (TMCTS) oder
im Falle, dass Schicht D aus Aluminiumoxid oder SiO2 ist
b) eine hochbrechende Metalloxidschicht, wobei die Metalloxide ausgewählt sind aus Titandioxid, Ta2O5,

ZrO2, Nb2O5 und HfO sein kann und optional eine weitere Schicht gemäß Schicht E (a), eine Plasmapolymerschicht, aufgebracht sein kann.

2. Mehrschichtaufbau gemäß Anspruch 1, wobei der thermoplastische Kunststoff ausgewählt ist aus mindestens einem aus der Gruppe bestehend aus Polycarbonat, Polystyrol, Styrol-Copolymere, aromatische Polyester cyclische Polyolefine, Poly- oder Copolyacrylate und Poly- oder Copolymethacrylat, Copolymere mit Styrol thermoplastische Polyurethane, Polymere auf Basis von zyklischen Olefinen, Polycarbonat Blends mit olefinischen Copolymeren oder Pfropfpolymeren, wie beispielsweise Styrol/Acrylnitril Copolymeren.

3. Mehrschichtaufbau gemäß Anspruch 1, wobei Schicht B aus Titan ist.

4. Mehrschichtaufbau gemäß Anspruch 1, wobei Schicht C aus Silber oder Silberlegierungen, wobei die Silberlegierung Anteile von kleiner 10 Gew.-% an Gold, Platin, Palladium und/oder Titan aufweist, sowie Aluminium.

5. Mehrschichtaufbau gemäß Anspruch 4, wobei Schicht C aus Silber ist.

6. Mehrschichtaufbau gemäß Anspruch 1, wobei Schicht D aus Aluminiumoxid (AlOx) oder Titandioxid ist.

7. Mehrschichtaufbau gemäß Anspruch 1, wobei Schicht E Hexamethyldisiloxan ist.

8. Mehrschichtaufbau gemäß Anspruch 1, wobei die Schichtdicken der Schichten wie folgt ist:

Gesamtdicke der Schicht A: 1 μm - 10 mm im Falle von Thermoplasten, 300 μm - 750 μm im Falle von metallischen Substraten, 750 μm - 3 mm im Falle von Glas,
Schicht B: 40 nm- 250 nm,
Schicht C: 80 nm - 250 nm,
Schicht D: 80 nm - 250 nm
Schicht E 1 nm - 200 nm.

9. Mehrschichtaufbau gemäß Anspruch 1, wobei Schicht A eine Gesamtschichtdicke von 1 mm bis 5 mm aufweist.

10. Mehrschichtaufbau gemäß Anspruch 1, wobei die Schichtdicke der Schicht B 80 bis 130 nm beträgt.

11. Mehrschichtaufbau gemäß Anspruch 1, wobei Schicht B aus Titan ist und eine Schichtdicke von 105nm bis 120 nm beträgt.

12. Mehrschichtaufbau gemäß Anspruch 1, wobei die Schichtdicke der Schicht C 90 nm bis 160 nm, die der Schicht D 90 nm bis 160 nm beträgt und die der Schicht E 20 nm bis 100 nm beträgt.

13. Mehrschichtaufbau gemäß Anspruch 1, wobei der Thermoplast ausgewählt ist aus der Gruppe bestehend aus Polycarbonat, aromatischen Polyestern und Polycarbonat Blends, wobei diese Thermoplasten Füllstoffe enthalten können.

14. Verwendung des Mehrschichtaufbaus gemäß Anspruch 1 als Reflektor in Photovoltaikmodulen, Solarmodulen, in Beleuchtungssystemen, als Spiegel im Wohnbereich sowie im Fahrzeugbereich, als Reflektor in Lichtleitsystemen.

15. Photovoltaikmodule, Solarmodule, Beleuchtungssysteme, Lichtleitsysteme enthaltend einen Mehrschichtaufbau gemäß Anspruch1.

16. Spiegel enthaltend einen Mehrschichtaufbau gemäß Anspruch 1.

**Claims**

1. Multilayer assembly comprising five layers:

layer A: a substrate layer selected from a thermoplastic, metal and glass;
layer B: a barrier layer selected from titanium, gold, palladium, platinum, vanadium and tantalum; in the case

where the substrate layer is glass, the barrier layer can also be made of chromium or alloys of chromium with Co, Mo, Ni and/or Fe;
layer C: a reflective metallic layer;
layer D: an oxidic layer with a thickness of 80 nm - 250 nm, selected from aluminium oxide ($AlO_x$), titanium dioxide, $SiO_2$, $Ta_2O_5$, $ZrO_2$, $Nb_2O_5$ and HfO;
layer E:

a) a plasma polymer layer (anticorrosive layer) deposited from siloxane precursors selected from hexamethyldisiloxane (HMDSO), octamethylcyclotetrasiloxane (OMCTS), octamethyltrisiloxane (OMTS), tetraethylorthosilane (TEOS) and tetramethyldisiloxane (TMDSO), decamethylcyclopentasiloxane (DMCPS), hexamethylcyclotrisiloxane (HMCTS), trimethoxymethylsilane (TMOMS) and tetramethylcyclotetrasiloxane (TMCTS); alternatively, in the case where layer D consists of aluminium oxide or $SiO_2$, layer E can be
b) a highly refractive metal oxide layer, the metal oxides being selected from titanium dioxide, $Ta_2O_5$, $ZrO_2$, $Nb_2O_5$ and HfO, and another layer as defined in layer E (a), i.e. a plasma polymer layer, can optionally be applied.

2. Multilayer assembly according to Claim 1 wherein the thermoplastic is selected from at least one of the group comprising polycarbonate, polystyrene, styrene copolymers, aromatic polyesters, cyclic polyolefins, poly- or copolyacrylates and poly- or copolymethacrylate, copolymers with styrene, thermoplastic polyurethanes, polymers based on cyclic olefins, and polycarbonate blends with olefinic copolymers or graft polymers, e.g. styrene/acrylonitrile copolymers.

3. Multilayer assembly according to Claim 1 wherein layer B consists of titanium.

4. Multilayer assembly according to Claim 1 wherein layer C consists of silver or silver alloys, the silver alloy containing less than 10 wt% of gold, platinum, palladium and/or titanium, and aluminium.

5. Multilayer assembly according to Claim 4 wherein layer C consists of silver.

6. Multilayer assembly according to Claim 1 wherein layer D consists of aluminium oxide ($AlO_x$) or titanium dioxide.

7. Multilayer assembly according to Claim 1 wherein layer E is hexamethyl-disiloxane.

8. Multilayer assembly according to Claim 1 wherein the thicknesses of the layers are as follows:

total thickness of layer A: 1 $\mu$m - 10 mm in the case of thermoplastics, 300 $\mu$m - 750 $\mu$m in the case of metallic substrates, 750 $\mu$m - 3 mm in the case of glass,
layer B: 40 nm - 250 nm,
layer C: 80 nm - 250 nm,
layer D: 80 nm - 250 nm,
layer E: 1 nm - 200 nm.

9. Multilayer assembly according to Claim 1 wherein layer A has a total thickness of 1 mm to 5 mm.

10. Multilayer assembly according to Claim 1 wherein the thickness of layer B is 80 to 130 nm.

11. Multilayer assembly according to Claim 1 wherein layer B consists of titanium and has a thickness of 105 nm to 120 nm.

12. Multilayer assembly according to Claim 1 wherein the thickness of layer C is 90 nm to 160 nm, that of layer D is 90 nm to 160 nm and that of layer E is 20 nm to 100 nm.

13. Multilayer assembly according to Claim 1 wherein the thermoplastic is selected from the group comprising polycarbonate, aromatic polyesters and polycarbonate blends, it being possible for these thermoplastics to contain fillers.

14. Use of the multilayer assembly according to Claim 1 as a reflector in photovoltaic panels, solar panels and lighting systems, as a mirror in residential environments and in the vehicle sector, and as a reflector in light guide systems.

15. Photovoltaic panels, solar panels, lighting systems and light guide systems comprising a multilayer assembly according to Claim 1.

**16.** Mirror comprising a multilayer assembly according to Claim 1.

**Revendications**

**1.** Structure multicouche, contenant cinq couches

couche A : une couche de substrat, choisie parmi un plastique thermoplastique, un métal ou le verre,
couche B : une couche de barrière, choisie parmi le titane, l'or, le palladium, le platine, le vanadium ou le tantale, la couche de barrière, si la couche de substrat est en verre, pouvant en outre être en chrome ou en alliages de chrome avec Co, Mo, Ni et/ou Fe.
couche C : une couche de réflecteur métallique,
couche D : une couche oxydique dont l'epaisseur est de 80 nm - 250 nm, choisie parmi l'oxyde d'aluminium ($AlO_x$), le dioxyde de titane, $SiO_2$, $Ta_2O_5$, $ZrO_2$, $Nb_2O_5$ et HfO,
couche E :

a) une couche de polymère plasma (couche anticorrosion) déposée à partir de précurseurs de siloxane choisis parmi l'hexaméthyldisiloxane (HMDSO), l'octaméthylcyclotétrasiloxane (OMCTS), l'octaméthyltrisiloxane (OMTS), le tétraéthylorthosilane (TEOS), et le tétraméthyldisiloxane (TMDSO), le décaméthylcyclopentasiloxane (DMDMS), l'hexaméthylcyclotrisiloxane (HMCTS), le triméthoxyméthylsilane (TMOMS) et le tétraméthylcyclotétrasiloxane (TMCTS), ou
lorsque la couche D est en oxyde d'aluminium ou $SiO_2$,
b) une couche d'oxyde métallique d'indice de réfraction élevé, les oxydes métalliques étant choisis parmi le dioxyde de titane, $Ta_2O_5$, $ZrO_2$, $Nb_2O_5$ et HfO, et une couche supplémentaire selon la couche E (a) une couche de polymère plasma peut éventuellement être appliquée.

**2.** Structure multicouche selon la revendication 1, dans laquelle le plastique thermoplastique est choisi parmi au moins un du groupe constitué par le polycarbonate, le polystyrène, les copolymères de styrène, les polyesters aromatiques, les polyoléfines cycliques, les poly- ou copolyacrylates et les polyou copolyméthacrylates, les copolymères avec du styrène, les polyuréthanes thermoplastiques, les polymères à base d'oléfines cycliques, les mélanges de polycarbonate avec des polymères greffés ou des copolymères oléfiniques, tels que par exemple des copolymères de styrène/acrylonitrile

**3.** Structure multicouche selon la revendication 1, dans laquelle la couche B est en titane.

**4.** Structure multicouche selon la revendication 1, dans laquelle la couche C est en argent ou en alliages d'argent, l'alliage d'argent comprenant des proportions inférieures à 10% en poids d'or, de platine, de palladium et/ou de titane, ainsi que d'aluminium.

**5.** Structure multicouche selon la revendication 4, dans laquelle la couche C est en argent.

**6.** Structure multicouche selon la revendication 1, dans laquelle la couche D est en oxyde d'aluminium ($AlO_x$) ou en dioxyde de titane.

**7.** Structure multicouche selon la revendication 1, dans laquelle la couche E est en hexaméthyldisiloxane.

**8.** Structure multicouche selon la revendication 1, dans laquelle les épaisseurs de couche des couches sont les suivantes :

épaisseur totale de la couche A : 1 $\mu$m à 10 mm dans le cas de thermoplastiques, 300 $\mu$m à 750 $\mu$m dans le cas de substrats métalliques, 750 $\mu$m à 3 mm dans le cas de verre,
couche B : 40 nm à 250 nm,
couche C : 80 nm à 250 nm,
couche D : 80 nm à 250 nm,
couche E : 1 nm à 200 nm.

9. Structure multicouche selon la revendication 1, dans laquelle la couche A a une épaisseur totale de couche de 1 mm à 5mm.

10. Structure multicouche selon la revendication 1, dans laquelle l'épaisseur de couche de la couche B est de 80 à 130 nm.

11. Structure multicouche selon la revendication 1, dans laquelle la couche B est en titane et l'épaisseur de couche est de 105 nm à 120 nm.

12. Structure multicouche selon la revendication 1, dans laquelle l'épaisseur de couche de la couche C est de 90 nm à 160 nm, de la couche D de 90 nm à 160 nm, et de la couche E de 20 nm à 100 nm.

13. Structure multicouche selon la revendication 1, dans laquelle le thermoplastique est choisi dans le groupe constitué par le polycarbonate, les polyesters aromatiques et les mélanges de polycarbonate, ces thermoplastiques pouvant contenir des charges.

14. Utilisation de la structure multicouche selon la revendication 1 en tant que réflecteur dans des modules photovoltaïques, des modules solaires, dans des systèmes d'éclairage, en tant que miroir dans le domaine résidentiel, ainsi que dans le domaine automobile, en tant que réflecteur dans les systèmes de conduits de lumière.

15. Modules photovoltaïques, modules solaires, systèmes d'éclairage, systèmes de conduits de lumière contenant une structure multicouche selon la revendication 1.

16. Miroir contenant une structure multicouche selon la revendication 1.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2000007818 A
- US 6078425 A
- EP 1657281 A
- EP 1582549 A1
- WO 2008037364 A1
- WO 2006040087 A
- DE S2035390 O
- US S3644574 A
- DE S2248242 O
- GB S1409275 A
- EP 0839623 A
- WO 9615102 A
- EP 0500496 A
- WO 2010127805 A
- WO 2010085909 A


### In der Beschreibung aufgeführte Nicht-Patentliteratur


- *Tantaloxidschichten soll in Society of Vacuum Coaters,* 2009, 473-477
- *Aus Concentrating Photovoltaic Conference 7 (CPV 7),* April 2011
- *Surface and Coatings Technology,* 1999, vol. 111, 278-296
- *Publikation Applied Optics,* 15. April 1985, vol. 24 (8), 1164-1170
- **ULLMANNS.** Enzyklopädie der Technischen Chemie. 1980, vol. 19, 280 ff
- **HANS ZWEIFEL.** Plastics Additives Handbook. Hanser Verlag, 2000
- Vakuumbeschichtung. VDI Verlag, 1995, vol. 1-5
- **H. FREY.** Vakuumbeschichtung. VDI-Verlag Düsseldorf, 1995, vol. 1 bis 5
- **R.A. HAEFER.** Oberflächen- und Dünnschicht-Technologie. Springer Verlag, 1987
- **FRIEDRICH et al.** Fundamental and applied aspects. *Metallized plastics,* vol. 5 & 6
- **H. GRÜNWALD et al.** *Surface and Coatings Technology,* 1999, vol. 111, 287-296
- *Surface and Coatings Technology,* 1999, vol. 111, 287-296